# FASCICULE DE BREVET EUROPEEN

(11) **EP 3 244 456 B1**
(45) Date de publication et mention de la délivrance du brevet: **27.03.2019**
(21) Numéro de dépôt: 17169339.3
(22) Date de dépôt: 03.05.2017
(51) Int. Cl.: H01L 31/042, H02S 40/42, H02S 40/36

(54) **MODULE PHOTOVOLTAÏQUE COMPRENANT DES CELLULES PHOTOVOLTAÏQUES DISPOSÉES SELON DES ORIENTATIONS DIFFÉRENTES ET INSTALLATION PHOTOVOLTAÏQUE ASSOCIÉE**
FOTOVOLTAIKMODUL, DAS FOTOVOLTAIKZELLEN UMFASST, DIE IN UNTERSCHIEDLICHEN AUSRICHTUNGEN ANGEORDNET SIND, UND ENTSPRECHENDE FOTOVOLTAIKANLAGE
PHOTOVOLTAIC MODULE INCLUDING PHOTOVOLTAIC CELLS ARRANGED WITH DIFFERENT ORIENTATIONS AND ASSOCIATED PHOTOVOLTAIC SYSTEM

(30) Priorité: 09.05.2016 FR 1654129
(43) Date de publication de la demande: 15.11.2017
(73) Titulaire: Commissariat à l'énergie atomique et aux énergies alternatives, 75015 Paris (FR)
(72) Inventeur: MARTIN, Jean-Luc, 04800 ST-MARTIN DE BROMES (FR); COLIN, Hervé, 73290 LA MOTTE-SERVOLEX (FR); GAUME, Julien, 38510 VEZERONCE-CURTIN (FR); MEZZASALMA, Frédéric, 13090 AIX EN PROVENCE (FR)
(74) Mandataire: Brevalex

(56) Documents cités:
- FR-A1- 2 957 952
- FR-A1- 2 988 163
- JP-A- H10 308 524
- US-A1- 2013 160 824

## Description

### DOMAINE TECHNIQUE

La présente invention se rapporte au domaine de la génération d'électricité par le biais des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin. Elle concerne également le refroidissement de tels modules photovoltaïques.

L'invention peut être mise en oeuvre pour de nombreuses applications, avec ou sans refroidissement, étant particulièrement concernée par sa mise en oeuvre le long de canaux aériens de circulation d'eau, notamment des canaux d'irrigation, en particulier présents dans des zones à fort potentiel solaire. Elle peut aussi être appliquée pour des bâtiments tels que des habitats ou locaux industriels (tertiaires, commerciaux, ...), voire pour la conception de mobilier urbain, par exemple pour des abris-bus, des verrières, des finalités esthétiques, entre autres.

L'invention propose ainsi un module photovoltaïque comprenant des groupements de cellules photovoltaïques disposées selon des orientations différentes pour capter des flux lumineux provenant de directions différentes, ainsi qu'une installation photovoltaïque comportant un tel module.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre mince, présentant une épaisseur typiquement comprise entre 2 et 4 mm, classiquement de l'ordre de 3 mm, voire encore réalisée en un matériau polymère, par exemple du type polyfluorure de vinylidène (PVDF), éthylène tétrafluoroéthylène (ETFE), polycarbonate (PC) ou polyméthacrylate de méthyle (PMMA).

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

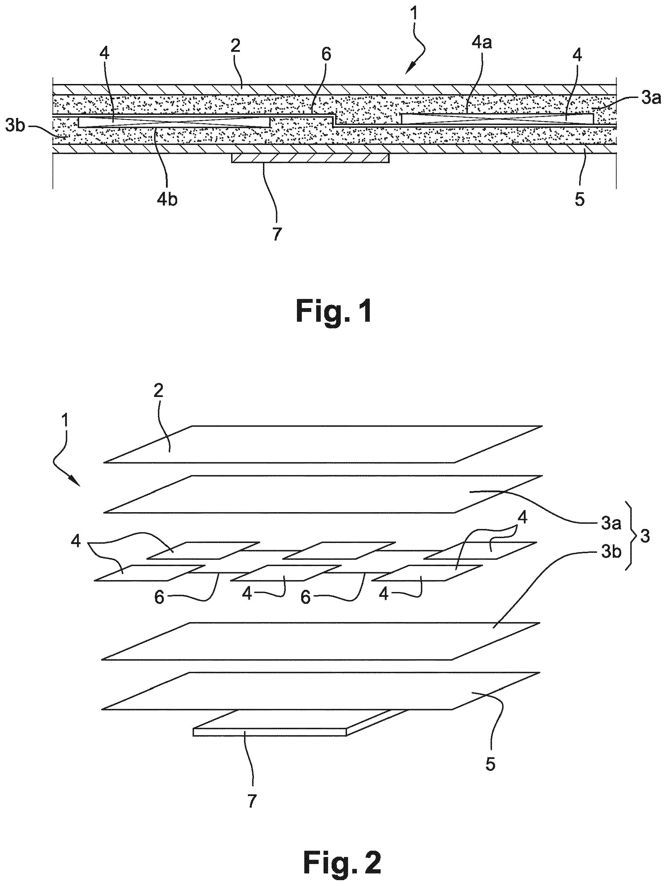

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 160°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard avec un poids surfacique de l'ordre de 12 kg/m². De nombreux fabricants proposent des modules photovoltaïques légers à base de silicium cristallin, soit avec un poids par unité de surface classiquement inférieur à 10 kg/m². La diminution ou la suppression du verre en face avant permettent de réduire considérablement le poids du module photovoltaïque, et les propriétés mécaniques de la face arrière peuvent être renforcées par le choix de matériaux adaptés.

Néanmoins, ces modules présentent le plus souvent des dimensions maximales faibles, n'excédant pas généralement 2 m², avec une longueur possible très inférieure à 3 m, ce qui les rend parfois non adaptables pour certaines applications pour lesquelles une grande surface est requise.

Par ailleurs, certaines de ces solutions connues ne sont pas suffisantes en termes de résistance à la charge. En effet, la trop grande flexibilité de certains modules, avec un positionnement de cellules photovoltaïques non optimisé, provoque des fissures sur ces dernières qui peuvent nuire au bon fonctionnement des modules sur le long terme.

De plus, ces solutions peuvent être insuffisantes en termes d'intégration. En effet, la plupart des modules photovoltaïques ne possède pas de moyens de fixation intégrés, ce qui oblige alors à coller et/ou à percer ces modules au risque de les endommager ou bien encore à se procurer des systèmes de fixation supplémentaires.

La fiabilité de certains des modules photovoltaïques connus peut également s'avérer insuffisante. En effet, peu d'études de fiabilité ont été réalisées sur les modules photovoltaïques légers, en particulier sur ceux n'ayant pas de verre en face avant, de sorte qu'il existe des incertitudes en termes de certifications.

Par ailleurs, de façon générale, le rendement d'une installation photovoltaïque en termes de production électrique est affecté par température du ou des modules photovoltaïques. Plus le module photovoltaïque est chaud, plus son rendement diminue. Le coefficient de dépendance de la production électrique du module photovoltaïque (à base de silicium monocristallin ou multicristallin) en fonction de sa température fait partie des caractéristiques standards fournies par un constructeur. Ce coefficient est de l'ordre de -0,4 %/°C à -0,5 %/°C.

température fait partie des caractéristiques standards fournies par un constructeur. Ce coefficient est de l'ordre de -0,4 %/°C à -0,5 %/°C.

Lorsqu'il est soumis à un flux solaire incident, un module photovoltaïque génère de l'électricité. Cependant, seule une première partie, de l'ordre de 15 à 20 %, du flux solaire incident sert à la génération d'électricité. Une deuxième partie du flux solaire incident est réfléchie et une troisième partie est absorbée par le module photovoltaïque. Cette troisième partie est dissipée thermiquement provoquant une montée en température du module photovoltaïque, et donc une dégradation de son rendement et un vieillissement accéléré.

Aussi, la température finale du module photovoltaïque dépend de cette troisième partie absorbée du flux solaire incident, non convertie en électricité, ainsi que de la capacité du module photovoltaïque à évacuer cette chaleur par convection, par conduction et échange radiatif.

Des solutions de refroidissement de modules photovoltaïques ont déjà été développées dans l'art antérieur, mettant en oeuvre par exemple une pulvérisation d'eau sur les modules photovoltaïques ou une production simultanée d'eau chaude et d'électricité. Toutefois, ces solutions ne sont pas entièrement satisfaisantes car elles impliquent de nombreuses contraintes, par exemple l'utilisation de réserves de stockage d'eau conséquentes en lien avec un système performant et très énergivore de refroidissement de cette eau, le maintien d'une température élevée des modules photovoltaïques lorsqu'une production d'eau chaude est souhaitée en parallèle de celle d'électricité, voire encore l'apparition de salissures, par exemple dues au calcaire de l'eau, à la surface des modules, néfastes à leur bon fonctionnement, entre autres.

FR 2 957 952 A décrit un élément photovoltaïque réalisé par encapsulation directe de cellules photovoltaïques sous une tuile transparente à fort galbe.

### EXPOSÉ DE L'INVENTION

Il existe ainsi un besoin pour concevoir une solution alternative de module photovoltaïque souple, permettant notamment une production d'énergie électrique sur au moins deux directions. Ce module photovoltaïque est avantageusement associé à un principe de refroidissement actif du module photovoltaïque, ainsi qu'à un concept de support innovant du module photovoltaïque.

En particulier, l'invention vise notamment à proposer une stratégie de refroidissement adaptée au principe du photovoltaïque. Elle cherche par exemple à refroidir les cellules photovoltaïques de façon homogène thermiquement afin de ne pas créer de déséquilibre thermique à l'intérieur du module photovoltaïque et de ne pas engendrer ainsi un dysfonctionnement et un vieillissement prématuré de l'installation comportant le module.

L'invention a ainsi pour objet, selon l'un de ses aspects, une installation photovoltaïque telle que définie par l'objet de la revendication 1, cette installation comprenant entre autre un module photovoltaïque, caractérisé en ce qu'il comporte :
- une première couche transparente formant la face avant du module photovoltaïque, destinée à recevoir un flux lumineux,
- une pluralité de cellules photovoltaïques réparties selon au moins deux groupements de cellules photovoltaïques, espacés les uns des autres, chaque groupement de cellules photovoltaïques comportant des cellules photovoltaïques disposées côte à côte et interconnectées électriquement entre elles, lesdits au moins deux groupements de cellules photovoltaïques du module photovoltaïque étant non reliés électriquement entre eux,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches,
lesdits au moins deux groupements de cellules photovoltaïques étant disposés au sein du module photovoltaïque selon au moins deux orientations différentes de sorte à recevoir des flux lumineux provenant d'au moins deux directions différentes.
De cette façon, le module photovoltaïque selon l'invention est apte à pouvoir capter les flux lumineux selon au moins deux directions différentes.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau d'encapsulation, réunies entre elles après lamination pour former l'ensemble encapsulant.

En effet, initialement, c'est-à-dire avant toute opération de lamination, l'ensemble encapsulant est constitué par au moins deux couches de matériau d'encapsulation, dites couches de coeur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Le module photovoltaïque peut en outre comporter l'une ou plusieurs des caractéristiques suivantes prises isolément ou suivant toutes combinaisons techniques possibles.

La première couche peut avantageusement être réalisée en au moins un matériau polymère et/ou un matériau composite, et peut présenter une épaisseur supérieure ou égale à 0,1 mm.

La deuxième couche peut avantageusement être réalisée en au moins un matériau polymère et/ou un matériau composite et/ou en métal, et peut présenter une épaisseur supérieure ou égale à 0,1 mm.

Le module photovoltaïque peut préférentiellement comporter un système de refroidissement, situé au moins partiellement à l'intérieur du module photovoltaïque, permettant la circulation d'un fluide de refroidissement, notamment de l'eau, à l'intérieur du module photovoltaïque.

Le module photovoltaïque peut comporter au moins un élément de connectique pour chaque groupement de cellules photovoltaïques de sorte à relier électriquement chaque groupement du module photovoltaïque à un groupement correspondant de cellules photovoltaïques d'un module photovoltaïque adjacent du même type.

Par ailleurs, la première couche et/ou la deuxième couche peuvent être réalisées en au moins un matériau polymère, par exemple texturé ou non texturé, notamment choisi parmi : le polycarbonate (PC), le polyméthacrylate de méthyle (PMMA), notamment du PMMA monophasé (non choc) ou du PMMA multi-phasé (choc), par exemple du PMMA choc nanostructuré, tel que celui commercialisé par la société Altuglas® sous la marque Altuglas® Shield-Up®, le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytetrafluoroéthylène (PTFE) et/ou le polychlorotrifluoroéthylène (PCTFE).

La première couche et/ou la deuxième couche peuvent encore être réalisées en au moins un matériau composite, notamment de type préimprégné (également appelé prépeg) à base de fibres de verre et de résine époxy.

La deuxième couche peut encore être réalisée en métal, notamment en aluminium.

En particulier, la première couche et la deuxième couche peuvent être réalisées en au moins un matériau polymère et peuvent présenter la même épaisseur.

En outre, l'ensemble encapsulant peut être réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

De préférence, l'ensemble encapsulant peut être réalisé à partir de deux couches de poly(éthylène-acétate de vinyle) (EVA) d'épaisseur au moins égal à 200 µm, entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres.

Par ailleurs, les cellules photovoltaïques peuvent présenter une épaisseur comprise entre 100 et 250 µm.

Le module photovoltaïque peut en outre comporter une boîte de jonction, destinée à recevoir le câblage nécessaire à l'exploitation du module photovoltaïque.

Par ailleurs, quand bien même la première couche formant la face avant du module photovoltaïque est transparente, la deuxième couche formant la face arrière du module photovoltaïque peut être ou non transparente, étant notamment opaque.

En outre, l'espacement entre deux cellules photovoltaïques voisines, ou encore consécutives ou adjacentes, d'un même groupement peut être supérieur ou égal à 1 mm, notamment compris entre 1 et 30 mm, et de préférence égal à 3 mm.

De plus, la réalisation du module photovoltaïque selon l'invention peut mettre en oeuvre une étape de lamination à chaud, notamment à une température supérieure ou égale à 120°C et pendant une durée du cycle de lamination d'au moins 10 minutes, d'au moins une partie des couches constitutives du module photovoltaïque.

Par ailleurs , l'installation photovoltaïque selon l'invention est caractérisée en ce qu'elle comporte :
- un ensemble d'au moins un premier module photovoltaïque et un deuxième module photovoltaïque tels que définis précédemment, positionnés de telle sorte qu'un groupement de cellules photovoltaïques du premier module photovoltaïque soit adjacent et relié électriquement à un groupement de cellules photovoltaïques du deuxième module photovoltaïque avec la même orientation pour recevoir un flux lumineux selon la même direction,
- une structure de support de l'ensemble desdits au moins un premier module photovoltaïque et un deuxième module photovoltaïque.

Chaque groupement de cellules photovoltaïques des premier et deuxième modules photovoltaïques comporte un élément de connectique de sorte que chaque groupement du premier module photovoltaïque soit relié électriquement à un groupement du deuxième module photovoltaïque présentant la même orientation pour recevoir un flux lumineux selon la même direction par le biais de leur élément de connectique.

L'installation peut en outre comporter un circuit fermé de refroidissement de l'ensemble desdits au moins un premier module photovoltaïque et un deuxième module photovoltaïque, comprenant le système de refroidissement de chaque module photovoltaïque, au moins en partie supportée par la structure de support.

La structure de support peut comporter au moins deux bras de support, destinés à s'étendre de part et d'autre d'une source en fluide de refroidissement, notamment un canal d'irrigation, et supportant respectivement les extrémités de l'ensemble desdits au moins un premier module photovoltaïque et un deuxième module photovoltaïque.

L'installation photovoltaïque peut en outre comporter des éléments de fixation, notamment des vis de type Krinner, destinés à être fixés de part et d'autre de la source en fluide de refroidissement, pour le maintien en position desdits au moins deux bras de support.

L'installation photovoltaïque peut de plus comporter au moins deux éléments de positionnement, notamment des blocs spécifiques, permettant le maintien en position de l'ensemble desdits au moins un premier module photovoltaïque et un deuxième module photovoltaïque, supportés respectivement par lesdits au moins deux bras de support. Chaque élément de positionnement peut comporter une partie supérieure et une partie inférieure, destinées à être assemblées entre elles, l'assemblage des parties supérieure et inférieure définissant un support d'une extrémité de l'ensemble desdits au moins un premier module photovoltaïque et un deuxième module photovoltaïque. Chaque élément de positionnement peut supporter au moins en partie le circuit de refroidissement de l'installation photovoltaïque, et notamment le système de refroidissement de chaque module photovoltaïque.

Par ailleurs, le circuit de refroidissement peut comporter, au niveau de l'une des extrémités de l'ensemble desdits au moins un premier module photovoltaïque et un deuxième module photovoltaïque supportée par l'un desdits au moins deux bras de support, une arrivée de fluide de refroidissement provenant de la source en fluide de refroidissement, et au niveau de l'autre des extrémités de l'ensemble desdits au moins un premier module photovoltaïque et un deuxième module photovoltaïque supportée par l'autre desdits au moins deux bras de support, une évacuation de fluide de refroidissement réchauffé.

En outre, le circuit de refroidissement peut comporter un circulateur relié à un échangeur de chaleur thermique.

De façon avantageuse, le module photovoltaïque peut être suffisamment grand et conformable pour s'adapter à la structure de support de l'installation photovoltaïque conforme à l'invention.

L'installation photovoltaïque selon l'invention peut comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'un exemple de mise en oeuvre non limitatif de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- la figure 3 illustre, en vue de dessus et à plat, un exemple de réalisation d'un ensemble de modules photovoltaïques,
- la figure 4 illustre, très schématiquement en coupe, l'ensemble de modules photovoltaïques de la figure 3 de sorte à visualiser la flèche de l'ensemble,
- les figures 5A et 5B illustrent, selon des vues en perspective différentes, un exemple de réalisation d'une installation photovoltaïque comportant l'ensemble de modules photovoltaïques conformes à l'invention de la figure 3, et
- la figure 6 est une vue en perspective agrandie de la zone A de la figure 5B.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ D'UN MODE DE RÉALISATION PARTICULIER

Les figures 1 et 2 ont déjà été décrites dans la partie relative à l'état de la technique antérieure.

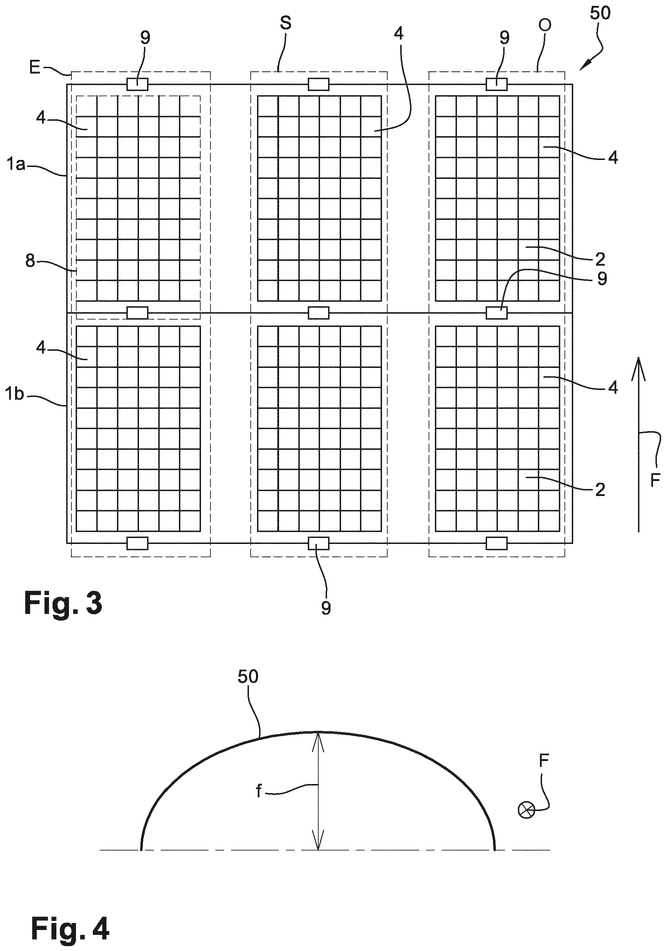

Les figures 3, 4, 5A, 5B et 6 se réfèrent à un exemple non limitatif de réalisation de l'invention, mise en oeuvre au-dessus d'un canal d'irrigation C dont l'eau constitue le fluide de refroidissement. Il est d'ailleurs à noter que, sur les figures 3 et 4, la flèche F représente la direction du canal d'irrigation C.

Par ailleurs, bien que non représenté de façon semblable sur les figures 3 à 6, chaque module photovoltaïque 1a, 1b comporte un empilement de couches du type de celui décrit en référence aux figures 1 et 2. Aussi, les références utilisées par la suite qui ne sont pas représentées sur les figures 3 à 6 se réfèrent à celles utilisées sur les figures 1 et 2 par analogie.

La figure 3 illustre ainsi tout d'abord, en vue de dessus et à plat, un exemple de réalisation d'un ensemble 50 conforme à l'invention d'un premier module photovoltaïque la et d'un deuxième module photovoltaïque 1b. Les deux modules photovoltaïques la et 1b sont reliés électriquement entre eux par le biais d'éléments de connectique 9 du type Plug&Play.

Plus précisément, chaque module photovoltaïque 1a, 1b comporte trois groupements 8, espacés les uns des autres, de cellules photovoltaïques 4 interconnectées. Chaque groupement 8 d'un des deux modules photovoltaïques 1a, 1b comporte au moins un élément de connectique 9 pour permettre de le relier électriquement à un groupement correspondant 8 de l'autre des deux modules photovoltaïques 1a, 1b.

Ces groupements 8 présentent avantageusement des orientations différentes pour recevoir des flux lumineux provenant de différentes directions. Autrement dit, le module photovoltaïque 1a, 1b selon l'invention permet la production d'énergie électrique sur au moins trois directions différentes. En particulier, les groupements 8 situés à gauche de la figure 3, identifiés par le contour E en traits pointillés, sont exposés dans la direction de l'est. Les groupements 8 situés au centre de la figure 3, identifiés par le contour S en traits pointillés, sont exposés dans la direction du sud. Enfin, les groupements 8 situés à droite de la figure 3, identifiés par le contour O en traits pointillés, sont exposés dans la direction de l'ouest. Ces différences d'orientation des groupements 8 permettent avantageusement d'optimiser le rendement photovoltaïque.

Les groupements 8 d'un même module photovoltaïque 1a ou 1b ne sont pas reliés électriquement entre eux. En revanche, un groupement 8 du premier module photovoltaïque la est relié électriquement à un groupement 8 correspondant adjacent de même orientation pour la captation d'un flux lumineux de même direction du deuxième module photovoltaïque 1b. Ainsi, les groupements 8 du premier module photovoltaïque la sont chacun reliés électriquement aux groupements 8 du deuxième module photovoltaïque 1b, afin de séparer les contraintes mécaniques des contraintes électriques.

Par ailleurs, chaque module photovoltaïque 1a, 1b comporte une première couche 2 transparente formant la face avant du module photovoltaïque 1a, 1b, destinée à recevoir un flux lumineux; une pluralité de cellules photovoltaïques 4 réparties selon les groupements 8 dans lesquels elles sont disposées côte à côte et reliées électriquement entre elles mais pas entre groupements 8 ; un ensemble encapsulant 3 la pluralité de cellules photovoltaïques 4 ; et une deuxième couche 5 formant la face arrière du module photovoltaïque 1a, 1b, l'ensemble encapsulant 3 et la pluralité de cellules photovoltaïques 4 étant situés entre les première 2 et deuxième 5 couches.

De façon avantageuse, la première couche 2 est réalisée en au moins un matériau polymère et/ou un matériau composite, et présente une épaisseur supérieure ou égale à 0,1 mm. De même, la deuxième couche 5 est réalisée en au moins un matériau polymère et/ou un matériau composite et/ou en métal, et présente une épaisseur supérieure ou égale à 0,1 mm.

A l'inverse des modules photovoltaïques classiques de l'art antérieur, le module photovoltaïque 1a, 1b peut avoir des dimensions réalisées sur mesure, notamment fonction des besoins de l'application visée.

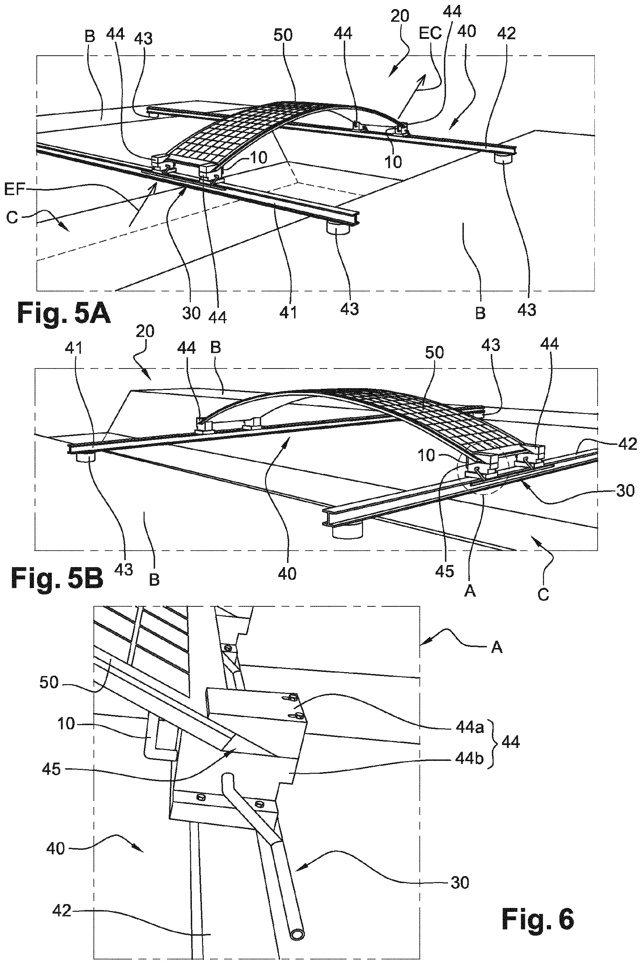

Par ailleurs, chaque module photovoltaïque 1a, 1b comporte avantageusement un système de refroidissement 10 (visible sur les figures 5A, 5B et 6), situé au moins partiellement à l'intérieur de chaque module photovoltaïque 1a, 1b, permettant la circulation d'un fluide de refroidissement à l'intérieur du module photovoltaïque 1a, 1b.

De façon préférentielle, le module photovoltaïque 1a, 1b est souple, c'est-à-dire qu'il peut accepter une flèche f, représentée sur la figure 4 pour plus de clarté, allant jusqu'à 50 % de la longueur initiale du module photovoltaïque 1a, 1b. Autrement dit, si L représente la longueur initiale de chaque module photovoltaïque 1a, 1b, ou encore de l'ensemble 50 des deux modules photovoltaïques 1a et 1b, alors la flèche f satisfait à la relation suivante : f ≤ 0,5 x L.

Par ailleurs, comme indiqué précédemment, la première couche 2 et/ou la deuxième couche 5 de chaque module photovoltaïque 1a, 1b peuvent être réalisées en au moins un matériau polymère, notamment choisi parmi : le polycarbonate (PC), le polyméthacrylate de méthyle (PMMA), notamment du PMMA monophasé (non choc) ou du PMMA multi-phasé (choc), par exemple du PMMA choc nanostructuré, le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), et/ou le Polychlorotrifluoroéthylène (PCTFE).

La première couche 2 et/ou la deuxième couche 5 de chaque module photovoltaïque 1a, 1b peuvent aussi être réalisées en au moins un matériau composite, notamment de type préimprégné (également appelé prépeg) à base de fibres de verre et de résine époxy, la deuxième couche 5 pouvant également être réalisée en métal, notamment en aluminium.

Les figures 5A et 5B illustrent quant à elles, selon des vues en perspective différentes, un exemple de réalisation d'une installation photovoltaïque 20 comportant l'ensemble 50 des deux modules photovoltaïques 1a et 1b conformes à l'invention de la figure 3, tandis que la figure 6 est une vue en perspective agrandie de la zone A de la figure 5B.

Ainsi, l'installation photovoltaïque 20 comporte une structure de support 40 des modules photovoltaïques 1a et 1b, et un circuit fermé de refroidissement actif 30 des modules photovoltaïques 1a et 1b, ce circuit de refroidissement 30 comprenant le système de refroidissement 10 de chaque module photovoltaïque 1a, 1b, au moins en partie supportée par la structure de support 40.

La structure de support 40 s'avère avantageusement être d'un faible coût et d'une simplicité de fabrication. Elle peut être pré-montée de sorte à permettre une installation rapide au-dessus du canal d'irrigation C. La structure de support 40 peut par exemple être une structure métallique en acier galvanisé, enjambant le canal d'irrigation C.

L'installation photovoltaïque 20 est avantageusement placée au-dessus du canal d'irrigation C, de part et d'autre des berges B du canal d'irrigation C, soit au-dessus d'une zone fraîche favorable au refroidissement des modules photovoltaïques 1a et 1b par l'évaporation de l'eau au-dessus du canal C mais également par l'utilisation de l'eau elle-même en tant que fluide contribuant au refroidissement dans le circuit de refroidissement 30 permettant de diminuer la température des modules photovoltaïques 1a et 1b.

La structure de support 40 comporte avantageusement deux bras de support 41 et 42, ou poutres de support, s'étendant de part et d'autre du canal d'irrigation C, et supportant respectivement les extrémités de l'ensemble 50 des modules photovoltaïques 1a et 1b.

Par ailleurs, des éléments de fixation 43, notamment des vis de type Krinner, sont disposées sur les berges B du canal d'irrigation C, au-delà des structures maçonnées du canal C, permettant la fixation des deux bras de support 41 et 42.

En outre, l'installation 20 comporte des blocs spécifiques 44, répartis le long des bras de support 41 et 42, permettant le maintien en position de l'ensemble des deux modules photovoltaïques 1a et 1b, lequel est inséré dans chaque support45 de blocs spécifiques 44. Plus précisément, chaque bloc spécifique 44 comporte une partie supérieure 44a et une partie inférieure 44b, destinées à être assemblées entre elles, l'assemblage des parties supérieure 44a et inférieure 44b définissant le support 45 d'une extrémité de l'ensemble 50 des modules photovoltaïques 1a et 1b.

La structure de support 40, comprenant les deux bras de support 41 et 42, ainsi que les blocs spécifiques 44 peuvent être assemblés en usine avant leur installation au niveau du canal d'irrigation C. L'ensemble peut éventuellement être assuré par un cerclage par câble pour éviter les arrachements provoqués par les efforts de prise au vent.

Par ailleurs, comme on le voit sur la figure 6, chaque bloc spécifique 44 supporte au moins en partie le circuit de refroidissement 30 de l'installation photovoltaïque 20, et notamment le système de refroidissement 10 de chaque module photovoltaïque 1a, 1b. En particulier, des conduits de refroidissement du système de refroidissement 10 et du circuit de refroidissement 30 circulent à l'intérieur des blocs spécifiques 44.

En outre, il est à noter que le circuit de refroidissement 30 comporte, au niveau de l'une des extrémités de l'ensemble 50 des deux modules photovoltaïques 1a et 1b supporté par le bras de support 41, une arrivée d'eau froide provenant du canal d'irrigation (fluide caloporteur en circuit fermé), comme schématisé par la flèche EF. De même, le circuit de refroidissement 30 comporte, au niveau de l'autre des extrémités de l'ensemble 50 des deux modules photovoltaïques 1a et 1b supporté par le bras de support 42, une évacuation d'eau chaude, comme schématisé par la flèche EC.

Le circuit de refroidissement 30, dont une partie correspond au système de refroidissement 10 de chaque module photovoltaïque 1a, 1b, participe activement au refroidissement de chaque module photovoltaïque 1a, 1b dédié à la production d'électricité. Ainsi, de façon avantageuse, le circuit de refroidissement 30 fonctionne en circuit fermé. Le déplacement de l'eau dans le circuit de refroidissement 30 permet de récupérer des calories de chaque module photovoltaïque 1a, 1b pour en abaisser la température, et donc en augmenter le rendement. Le système de refroidissement 10 de chaque module photovoltaïque 1a, 1b peut par exemple comporter un contact thermique avec la face arrière du module photovoltaïque 1a, 1b.

Le circuit de refroidissement 30 comporte préférentiellement un circulateur relié à un échangeur de chaleur thermique situé sur une paroi des berges B du canal d'irrigation C. Ainsi, l'usage de pompes puissantes peut être évité, ce qui diminue fortement les consommations électriques.

Avantageusement, l'utilisation d'un fluide de refroidissement, ici de l'eau, s'écoulant à l'intérieur de chaque module photovoltaïque 1a, 1b en circuit fermé permet d'une part d'assurer son refroidissement actif, et d'autre part d'éviter l'encrassement dû au calcaire de l'eau à la surface du module (un des inconvénients de l'art antérieur), qui en baisserait le rendement et demanderait des interventions fréquentes de nettoyage spécifique et coûteux du calcaire.

Plus généralement, l'invention permet de proposer une installation photovoltaïque 20 reposant sur l'usage d'une structure de support 40 de conception simple, et utilisant au moins deux modules photovoltaïques 1a, 1b permettant un refroidissement actif uniforme en circuit fermé par récupération des calories négatives dans l'eau du canal d'irrigation C, évitant ainsi les contraintes thermiques sur les cellules photovoltaïques 4. Il est donc possible d'obtenir un fonctionnement électrique non perturbé, favorisant le vieillissement des modules photovoltaïques 1a, 1b en évitant de les surchauffer.

Bien entendu, l'invention n'est pas limitée à l'exemple de réalisation qui vient d'être décrit. Diverses modifications peuvent y être apportées par l'homme du métier.

## Revendications

1. Installation photovoltaïque (20), **caractérisée en ce qu'**elle comporte :
- un ensemble (50) d'au moins un premier module photovoltaïque (1a) et un deuxième module photovoltaïque (1b),
- une structure de support (40) de l'ensemble (50) desdits au moins un premier module photovoltaïque (1a) et un deuxième module photovoltaïque (1b),
chaque module photovoltaïque (1a, 1b) comportant :
- une première couche (2) transparente formant la face avant du module photovoltaïque (1a, 1b), destinée à recevoir un flux lumineux,
- une pluralité de cellules photovoltaïques (4) réparties selon au moins deux groupements (8) de cellules photovoltaïques (4), espacés les uns des autres, chaque groupement (8) de cellules photovoltaïques (4) comportant des cellules photovoltaïques (4) disposées côte à côte et interconnectées électriquement entre elles, lesdits au moins deux groupements (8) de cellules photovoltaïques (4) du module photovoltaïque (1a, 1b) étant non reliés électriquement entre eux à l'intérieur dudit module photovoltaïque (1a, 1b),
- un ensemble encapsulant (3) la pluralité de cellules photovoltaïques (4),
- une deuxième couche (5) formant la face arrière du module photovoltaïque (1a, 1b), l'ensemble encapsulant (3) et la pluralité de cellules photovoltaïques (4) étant situés entre les première (2) et deuxième (5) couches, lesdits au moins deux groupements (8) de cellules photovoltaïques (4) étant disposés au sein du module photovoltaïque (1a, 1b) selon au moins deux orientations différentes de sorte à recevoir des flux lumineux provenant d'au moins deux directions différentes,
et lesdits au moins un premier module photovoltaïque (1a) et un deuxième module photovoltaïque (1b) étant positionnés de telle sorte qu'un groupement (8) de cellules photovoltaïques (4) du premier module photovoltaïque (1a) soit adjacent et relié électriquement à un groupement (8) de cellules photovoltaïques (4) du deuxième module photovoltaïque (1b) avec la même orientation pour recevoir un flux lumineux selon la même direction.

2. Installation selon la revendication 1, **caractérisé en ce que** la première couche (2) est réalisée en au moins un matériau polymère et/ou un matériau composite, et présente une épaisseur supérieure ou égale à 0,1 mm, et **en ce que** la deuxième couche (5) est réalisée en au moins un matériau polymère et/ou un matériau composite et/ou en métal, et présente une épaisseur supérieure ou égale à 0,1 mm.

3. Installation selon la revendication 1 ou 2, **caractérisé en ce que** chaque module photovoltaïque (1a, 1b) comporte un système de refroidissement (10), situé au moins partiellement à l'intérieur du module photovoltaïque (1a, 1b), permettant la circulation d'un fluide de refroidissement à l'intérieur du module photovoltaïque (1a, 1b).

4. Installation selon l'une quelconque des revendications précédentes, **caractérisé en ce que** chaque module photovoltaïque (1a, 1b) comporte au moins un élément de connectique (9) pour chaque groupement (8) de cellules photovoltaïques (4) de sorte à relier électriquement chaque groupement (8) du module photovoltaïque (1a) à un groupement (8) correspondant de cellules photovoltaïques (4) d'un module photovoltaïque (1b) adjacent du même type.

5. Installation selon l'une quelconque des revendications précédentes, **caractérisé en ce que** :
- la première couche (2) et/ou la deuxième couche (5) sont réalisées :
- en au moins un matériau polymère, notamment choisi parmi : le polycarbonate (PC), le polyméthacrylate de méthyle (PMMA), notamment du PMMA monophasé (non choc) ou du PMMA multi-phasé (choc), par exemple du PMMA choc nanostructuré, le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), et/ou le Polychlorotrifluoroéthylène (PCTFE), et/ou,
- en au moins un matériau composite, notamment de type préimprégné à base de fibres de verre et de résine époxy, et/ou,
- **en ce que** la deuxième couche (5) est réalisée en métal, notamment en aluminium.

6. Installation selon l'une quelconque des revendications précédentes, **caractérisé en ce que** les cellules photovoltaïques (4) sont choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS).

7. Installation selon l'une quelconque des revendications précédentes, **caractérisée en ce que** chaque groupement (8) de cellules photovoltaïques (4) des premier (1a) et deuxième (1b) modules photovoltaïques comporte un élément de connectique (9) de sorte que chaque groupement (8) du premier module photovoltaïque (1a) soit relié électriquement à un groupement (8) du deuxième module photovoltaïque (1b) présentant la même orientation pour recevoir un flux lumineux selon la même direction par le biais de leur élément de connectique (9).

8. Installation selon l'une quelconque des revendications précédentes, **caractérisée en ce qu'**elle comporte un circuit fermé de refroidissement (30) de l'ensemble (50) desdits au moins un premier module photovoltaïque (1a) et un deuxième module photovoltaïque (1b), comprenant le système de refroidissement (10) de chaque module photovoltaïque (1a, 1b), au moins en partie supporté par la structure de support (40).

9. Installation selon l'une quelconque des revendications précédentes, **caractérisée en ce que** la structure de support (40) comporte au moins deux bras de support (41, 42), destinés à s'étendre de part et d'autre d'une source en fluide de refroidissement (C), notamment un canal d'irrigation, et supportant respectivement les extrémités de l'ensemble (50) desdits au moins un premier module photovoltaïque (1a) et un deuxième module photovoltaïque (1b).

10. Installation selon la revendication 9, **caractérisée en ce qu'**elle comporte des éléments de fixation (43), notamment des vis de type Krinner, destinés à être fixés de part et d'autre de la source en fluide de refroidissement (C), pour le maintien en position desdits au moins deux bras de support (41, 42).

11. Installation selon la revendication 9 ou 10, **caractérisée en ce qu'**elle comporte au moins deux éléments de positionnement (44), notamment des blocs spécifiques (44), permettant le maintien en position de l'ensemble (50) desdits au moins un premier module photovoltaïque (1a) et un deuxième module photovoltaïque (1b), supportés respectivement par lesdits au moins deux bras de support (41, 42).

12. Installation selon la revendication 11, **caractérisé en ce que** chaque élément de positionnement (44) comporte une partie supérieure (44a) et une partie inférieure (44b), destinées à être assemblées entre elles, l'assemblage des parties supérieure (44a) et inférieure (44b) définissant un support (45) d'une extrémité de l'ensemble (50).

13. Installation selon la revendication 11 ou 12, **caractérisée en ce que** chaque élément de positionnement (44) supporte au moins en partie le circuit de refroidissement (30) de l'installation photovoltaïque (20), et notamment le système de refroidissement (10) de chaque module photovoltaïque (1a, 1b).

14. Installation selon l'une des revendications 9 à 13, **caractérisée en ce que** le circuit de refroidissement (30) comporte, au niveau de l'une des extrémités de l'ensemble (50) desdits au moins un premier module photovoltaïque (1a) et un deuxième module photovoltaïque (1b) supportée par l'un (41) desdits au moins deux bras de support (41, 42), une arrivée de fluide de refroidissement provenant de la source en fluide de refroidissement (C), et au niveau de l'autre des extrémités de l'ensemble (50) desdits au moins un premier module photovoltaïque (1a) et un deuxième module photovoltaïque (1b) supportée par l'autre (42) desdits au moins deux bras de support (41, 42), une évacuation de fluide de refroidissement réchauffé.

15. Installation selon l'une quelconque des revendications précédentes, **caractérisée en ce que** le circuit de refroidissement (30) comporte un circulateur relié à un échangeur de chaleur thermique.

## Patentansprüche

1. Fotovoltaikanlage (20), **dadurch gekennzeichnet, dass** sie enthält:
- eine Anordnung (50) aus zumindest einem ersten Fotovoltaikmodul (1a) und einem zweiten Fotovoltaikmodul (1b),
- eine Tragstruktur (40) zum Tragen der Anordnung (50) aus dem zumindest einen ersten Fotovoltaikmodul (1a) und dem zumindest einen zweiten Fotovoltaikmodul (1b),
wobei jedes Fotovoltaikmodul (1a, 1b) enthält:
- eine transparente erste Schicht (2), welche die Vorderseite des Fotovoltaikmoduls (1a, 1b) bildet, die dazu bestimmt ist, einen Lichtstrom aufzunehmen,
- eine Mehrzahl von Fotovoltaikzellen (4), die entlang von zumindest zwei Gruppen (8) von Fotovoltaikzellen (4) verteilt sind, die voneinander beabstandet sind, wobei jede Gruppe (8) von Fotovoltaikzellen (4) Fotovoltaikzellen (4) aufweist, die nebeneinander angeordnet und elektrisch miteinander verbunden sind, wobei die zumindest zwei Gruppen (8) von Fotovoltaikzellen (4) des Fotovoltaikmoduls (1a, 1b) innerhalb des Fotovoltaikmoduls (1a, 1b) nicht elektrisch miteinander verbunden sind,
- eine Kapselungsanordnung (3), welche die Mehrzahl von Fotovoltaikzellen (4) einkapselt,
- eine zweite Schicht (5), welche die Rückseite des Fotovoltaikmoduls (1a, 1b) bildet, wobei die Kapselungsanordnung (3) und die Mehrzahl von Fotovoltaikzellen (4) zwischen der ersten (2) und der zweiten Schicht (5) liegen, wobei die zumindest zwei Gruppen (8) von Fotovoltaikzellen (4) innerhalb eines Fotovoltaikmoduls (1a, 1b) in zumindest zwei verschiedenen Ausrichtungen angeordnet sind, so dass sie Lichtströme aus zumindest zwei verschiedenen Richtungen aufnehmen,
und wobei das zumindest eine erste Fotovoltaikmodul (1a) und das zumindest eine zweite Fotovoltaikmodul (1b) so angeordnet sind, dass eine Gruppe (8) von Fotovoltaikzellen (4) des ersten Fotovoltaikmoduls (1a) an eine Gruppe (8) von Fotovoltaikzellen (4) des zweiten Fotovoltaikmoduls (1b) mit der gleichen Ausrichtung angrenzt und elektrisch damit verbunden ist, um einen Lichtstrom in der gleichen Richtung aufzunehmen.

2. Anlage nach Anspruch 1, **dadurch gekennzeichnet, dass** die erste Schicht (2) aus zumindest einem Polymermaterial und/oder Verbundmaterial hergestellt ist und eine Dicke höher oder gleich 0,1 mm aufweist, und dass die zweite Schicht (5) aus zumindest einem Polymermaterial und/oder Verbundmaterial und/oder Metall hergestellt ist und eine Dicke höher oder gleich 0,1 mm aufweist.

3. Anlage nach Anspruch 1 oder 2, **dadurch gekennzeichnet, dass** jedes Fotovoltaikmodul (1a, 1b) ein Kühlsystem (10) enthält, das zumindest teilweise innerhalb des Fotovoltaikmoduls (1a, 1b) liegt und die Zirkulation eines Kühlmediums innerhalb des Fotovoltaikmoduls (1a, 1b) gestattet.

4. Anlage nach einem der vorangehenden Ansprüche, **dadurch gekennzeichnet, dass** jedes Fotovoltaikmodul (1a, 1b) zumindest ein Anschlusselement (9) für jede Gruppe (8) von Fotovoltaikzellen (4) enthält, so dass jede Gruppe (8) des Fotovoltaikmoduls (1a) mit einer entsprechenden Gruppe (8) von Fotovoltaikzellen (4) eines angrenzenden Fotovoltaikmoduls (1b) gleicher Art elektrisch verbunden ist.

5. Anlage nach einem der vorangehenden Ansprüche, **dadurch gekennzeichnet, dass** jedes
- die erste Schicht (2) und/oder die zweite Schicht (5) hergestellt sind aus:
- zumindest einem Polymermaterial, insbesondere ausgewählt aus: Polycarbonat (PC), Polymethylmethacrylat (PMMA), insbesondere einphasigem PMMA (nicht schlagfest) oder mehrphasigem PMMA (schlagfest), beispielsweise schlagfestem nanostrukturierten PMMA, Polyethylenterephthalat (PET), Polyamid (PA), Fluorpolymer, insbesondere Polyvinylfluorid (PVF) oder Polyvinylidenfluorid (PVDF), Ethylentetrafluorethylen (ETFE), Ethylenchlorotrifluorethylen (ECTFE), Polytetrafluorethylen (PTFE) und/oder Polychlorotrifluorethylen (PCTFE), und/oder
- zumindest einem Verbundmaterial, insbesondere vom Prepreg-Typ auf der Basis von Glasfasern und Epoxidharz, und/oder
- dass die zweite Schicht (5) aus Metall, insbesondere aus Aluminium, hergestellt ist.

6. Anlage nach einem der vorangehenden Ansprüche, **dadurch gekennzeichnet, dass** die Fotovoltaikzellen (4) ausgewählt sind aus: Fotovoltaikzellen mit Homoübergang oder Heteroübergang basierend auf monokristallinem (c-Si) oder multikristallinem Silicium (mc-Si), und/oder Fotovoltaikzellen mit zumindest einem Material aus amorphem Silicium (a-Si), mikrokristallinem Silicium (µC-Si), Cadmiumtellurid (CdTe), Kupfer-Indium-Selenid (CIS), Kupfer-Indium/Gallium-Diselenid (CIGS).

7. Anlage nach einem der vorangehenden Ansprüche, **dadurch gekennzeichnet, dass** jede Gruppe (8) von Fotovoltaikzellen (4) des ersten (1a) und zweiten (1b) Fotovoltaikmoduls ein Anschlusselement (9) enthält, derart, dass jede Gruppe (8) des ersten Fotovoltaikmoduls (1a) elektrisch mit einer Gruppe (8) des zweiten Fotovoltaikmoduls (1b) mit der gleichen Ausrichtung verbunden ist, um einen Lichtstrom in dergleichen Richtung über ihr Anschlusselement (9) aufzunehmen.

8. Anlage nach einem der vorangehenden Ansprüche, **dadurch gekennzeichnet, dass** sie einen geschlossenen Kühlkreis (30) zum Kühlen der Anordnung (50) aus dem zumindest einen ersten Fotovoltaikmodul (1a) und dem zumindest einen zweiten Fotovoltaikmodul (1b) enthält, der das Kühlsystem (10) eines jeden Fotovoltaikmoduls (1a, 1b) enthält, das zumindest teilweise von der Tragstruktur (40) getragen wird.

9. Anlage nach einem der vorangehenden Ansprüche, **dadurch gekennzeichnet, dass** die Tragstruktur (40) zumindest zwei Tragarme (41, 42) enthält, die dazu bestimmt sind, sich beiderseits einer Kühlmediumquelle (C) insbesondere eines Bewässerungskanals, zu erstrecken und die die jeweiligen Enden der Anordnung (50) aus dem zumindest einen ersten Fotovoltaikmodul (1a) und dem zumindest einen zweiten Fotovoltaikmodul (1b) trägt.

10. Anlage nach Anspruch 9, **dadurch gekennzeichnet, dass** sie Befestigungselemente (43) enthält, insbesondere Krinner-Schrauben, die dazu bestimmt sind, beiderseits der Kühlmediumquelle (C) zum Halten der zumindest zwei Tragarme (41, 42) in ihrer Stellung befestigt zu werden.

11. Anlage nach Anspruch 9 oder 10, **dadurch gekennzeichnet, dass** sie zumindest zwei Positionierungselemente (44), insbesondere spezifische Blöcke (44), enthält, die den Halt der Anordnung (50) aus dem zumindest einen ersten Fotovoltaikmodul (1a) und dem zumindest einen zweiten Fotovoltaikmodul (1b) in Stellung gestatten und von den zumindest zwei Tragarmen (41, 42) getragen werden.

12. Anlage nach Anspruch 11, **dadurch gekennzeichnet, dass** jedes Positionierungselement (44) einen oberen Abschnitt (44a) und einen unteren Abschnitt (44b) aufweist, die dazu bestimmt sind, zusammengefügt zu werden, wobei die Zusammenfügung des oberen (44a) und des unteren (44b) Abschnitts einen Träger (45) für ein Ende der Anordnung (50) definiert.

13. Anlage nach Anspruch 11 oder 12, **dadurch gekennzeichnet, dass** jedes Positionierungselement (44) zumindest teilweise den Kühlkreis (30) der Fotovoltaikanlage (20), insbesondere das Kühlsystem (10) eines jeden Fotovoltaikmoduls (1a, 1b), trägt.

14. Anlage nach einem der Ansprüche 9 bis 13, **dadurch gekennzeichnet, dass** der Kühlkreis (30) im Bereich von dem einem Ende der Anordnung (50) aus dem zumindest einen ersten Fotovoltaikmodul (1a) und dem zumindest einen zweiten Fotovoltaikmodul (1b), das von einem (41) der zumindest zwei Tragarme (41, 42) getragen wird, einen Zulauf für Kühlmedium von der Kühlmediumquelle (C) enthält, und im Bereich des anderen Endes der Anordnung (50) aus dem zumindest einen ersten Fotovoltaikmodul (1a) und dem zumindest einen zweiten Fotovoltaikmodul (1b), das von dem anderen (42) der zumindest zwei Tragarme (41, 42) getragen wird, einen Ablauf von erhitztem Kühlmedium enthält.

15. Anlage nach einem der vorangehenden Ansprüche, **dadurch gekennzeichnet, dass** der Kühlkreis (30) eine mit einem Wärmetauscher verbundene Umwälzpumpe enthält.

## Claims

1. A photovoltaic facility (20), **characterised in that** it includes:
- an assembly (50) of at least one first photovoltaic module (1a) and one second photovoltaic module (1b),
- a support structure (40) for supporting the assembly (50) of said at least one first photovoltaic module (1a) and one second photovoltaic module (1b),
each photovoltaic module (1a, 1b) including:
- a first transparent layer (2) forming the front face of the photovoltaic module (1a, 1b), for receiving a luminous flux,
- a plurality of photovoltaic cells (4) distributed according to at least two groups (8) of photovoltaic cells (4), spaced apart from each other, each group (8) of photovoltaic cells (4) including photovoltaic cells (4) disposed side by side and electrically interconnected to each other, said at least two groups (8) of photovoltaic cells (4) of the photovoltaic module (1a, 1b) being not electrically connected to each other inside said photovoltaic module (1a, 1b),
- an embedding assembly (3) for embedding the plurality of photovoltaic cells (4),
- a second layer(5) forming the rear face of the photovoltaic module (1a, 1b), the embedding assembly (3) and the plurality of photovoltaic cells (4) being located between the first (2) and second (5) layers, said at least two groups (8) of photovoltaic cells (4) being disposed within the photovoltaic module (1a, 1b) according to at least two different orientations so as to receive luminous fluxes from at least two different directions,
and said at least one first photovoltaic module (1a) and one second photovoltaic module (1b) being positioned such that a group (8) of photovoltaic cells (4) of the first photovoltaic module (1a) is adjacent and electrically connected to a group (8) of photovoltaic cells (4) of the second photovoltaic module (1b) with the same orientation to receive a luminous flux along the same direction.

2. The facility according to claim 1, **characterised in that** the first layer (2) is made of at least one polymeric material and/or one composite material, and has a thickness higher than or equal to 0.1mm, and **in that** the second layer (5) is made of at least one polymeric material and/or composite material and/or of metal, and has a thickness higher than or equal to 0.1mm.

3. The facility according to claim 1 or 2, **characterised in that** each photovoltaic module (1a, 1b) includes a cooling system (10), located at least partially inside the photovoltaic module (1a, 1b), enabling a cooling fluid to be circulated inside the photovoltaic module (1a, 1b).

4. The facility according to any of the preceding claims, **characterised in that** each photovoltaic module (1a, 1b) includes at least one connector element (9) for each group (8) of photovoltaic cells (4) so as to electrically connect each group (8) of the photovoltaic module (1a) to a corresponding group (8) of photovoltaic cells (4) of an adjacent photovoltaic module (1b) of the same type.

5. The facility according to any of the preceding claims, **characterised in that**:
- the first layer (2) and/or the second layer (5) are made:
- of at least one polymeric material, in particular chosen from: polycarbonate (PC), polymethyl methacrylate (PMMA), in particular single phase (non-impact) PMMA or multi-phase (impact) PMMA, for example nanostructured impact PMMA, polyethylene terephthalate (PET), polyamide (PA), a fluorinated polymer, in particular polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE), and/or polychlorotrifluoroethylene (PCTFE), and/or,
- of at least one composite material, for example of the glass fibre and epoxy resin based prepreg, and/or,
- **in that** the second layer (5) is made of metal, in particular of aluminium.

6. The facility according to any of the preceding claims, **characterised in that** the photovoltaic cells (4) are chosen from: homojunction or heterojunction photovoltaic cells based on single crystal (c-Si) and/or polycrystalline (mc-Si) silicon, and/or photovoltaic cells comprising at least one material chosen from amorphous silicon (a-Si), microcrystalline silicon (µC-Si), cadmium telluride (CdTe), copper-indium selenide (CIS) and copper-indium/gallium diselenide (CIGS).

7. The facility according to any of the preceding claims, **characterised in that** each group (8) of photovoltaic cells (4) of the first (1a) and second (1b) photovoltaic modules includes a connector element (9) such that each group (8) of the first photovoltaic module (1a) is electrically connected to a group (8) of the second photovoltaic module (1b) having the same orientation to receive a luminous flux along the same direction through their connector element (9).

8. The facility according to any of the preceding claims, **characterised in that** it includes a closed cooling circuit (30) for cooling the assembly (50) of said at least one first photovoltaic module (1a) and one second photovoltaic module (1b), comprising the cooling system (10) for cooling each photovoltaic module (1a, 1b), at least partly supported by the support structure (40).

9. The facility according to any of the preceding claims, **characterised in that** the support structure (40) includes at least two support arms (41, 42), for extending on either side of a cooling fluid source (C), in particular an irrigation channel, and supporting the ends of the assembly (50) of said at least one first photovoltaic module (1a) and one second photovoltaic module (1b) respectively.

10. The facility according to claim 9, **characterised in that** it includes attachment elements (43), in particular Krinner type screws, for being attached on either side of the cooling fluid source (C), for holding said at least two support arms (41, 42) in position.

11. The facility according to claim 9 or 10, **characterised in that** it includes at least two positioning elements (44), in particular specific blocks (44), enabling the assembly (50) of said at least one first photovoltaic module (1a) and one second photovoltaic module (1b), respectively supported by said at least two support arms (41, 42), to be held in position.

12. The facility according to claim 11, **characterised in that** each positioning element (44) includes an upper part (44a) and a lower part (44b), for being assembled to each other, the assembling of the upper (44a) and lower (44b) parts defining a support (45) for one end of the assembly (50).

13. The facility according to claim 11 or 12, **characterised in that** each positioning element (44) supports at least partly the cooling circuit (30) of the photovoltaic facility (20), and in particular the cooling system (10) of each photovoltaic module (1a, 1b).

14. The facility according to one of claims 9 to 13, **characterised in that** the cooling circuit (30) includes, at one of the ends of the assembly (50) of said at least one first photovoltaic module (1a) and one second photovoltaic module (1b) supported by one (41) of said at least two support arms (41, 42), a cooling fluid inlet from the cooling fluid source (C), and at the other of the ends of the assembly (50) of said at least one first photovoltaic module (1a) and one second photovoltaic module (1b) supported by the other (42) of said at least two support arms (41, 42), a heated cooling fluid outlet.

15. The facility according to any of the preceding claims, **characterised in that** the cooling circuit (30) includes a circulator connected to a thermal heat exchanger.
